# EUROPEAN PATENT SPECIFICATION

(11) **EP 0 282 653 B1**
(45) Date of publication and mention of the grant of the patent: **15.11.1995**
(21) Application number: 87200495.7
(22) Date of filing: 18.03.1987
(51) Int. Cl.: H01L 27/15

(54) **Monolithic integration of an array of light-emitting elements and driver electronics**
Monolithische Integration einer Matrix von lichtemittierenden Elementen und Steuerelektronik
Intégration monolithique d'une matrice d'éléments émetteurs de lumière et de l'électronique de contrôle

(43) Date of publication of application: 21.09.1988
(73) Proprietor: AGFA-GEVAERT naamloze vennootschap, 2640 Mortsel (BE)
(72) Inventor: Stevens, Joan, B-9880 Aalter (BE); Van Daele, Peter Paul, B-9300 Aalst (BE); Baets, Roeland Gustaaf, B-9000 Gent (BE)

(56) References cited:
- EP-A- 0 162 677
- EP-A- 0 199 852

## Description

### 1. Field of the invention.

The present invention relates to the monolithic integration of light-emitting devices and associated driver electronics on a single semiconductor substrate. A quasi-planar architecture for the optoelectrical integration is used.

### 2. Background of the invention

Apparatus for recording information upon a movable photoreceptor are known comprising a plurality of stationary pointlike light sources that are arranged in a row that extends transversely of the direction of displacement of the photoreceptor. Said pointlike light sources are individually energizable thereby information-wise exposing the photoreceptor in response to information signals as the photoreceptor moves past the row of light-emitting sources.

The light sources must be sufficiently small to achieve an acceptable image resolution and to obtain the visual impression of an uninterrupted transverse line.

To cover the width of a DIN A₄ photoreceptor size, namely 216 mm, a number of at least 2200 discrete light sources are required. This can be achieved by integrating a plurality of light-emitting diodes (LED) as an array of photoemitters on a monolithic chip.

So far it is economically feasible to produce defect-free LED arrays on monocrystalline substrates with a length limitation ranging between 1 and 10 mm.

In order to form arrays of a length up to 216 mm a multiplicity of small modules must be assembled in alignment according to the method described in EP-A-0.086.907.

However, each of these integrated optical light-emitting devices is to be driven by an electronic driver circuit. In the prior art such drivers are provided on an integrated circuit and are connected to the integrated LED array by classic wire-bonding techniques.

Since optical devices and electronic devices can be used to form a complex optoelectronic circuit, it is highly desirable to be able to integrate all devices on a single chip, yet provide the electrical insulation of the devices from one another for proper circuit operation.

Such integration is interesting from the viewpoint of reduced circuit size, reduced circuit cost in the long term, increased reliability. In addition, the functional capability of such devices is enhanced in terms of the speed and noise performances by the reduction of the parasitic reactances which results from the wire-bonding device interconnection.

An extended review of the state of the art concerning integration of optoelectronic devices on GaAs and InP substrates is given by S.R. Forrest in the J.Lightwave Technol., Vol. LT-3, no. 6, Dec. 1985 and O.Wada et al. in IEEE J.Quantum Electronics, Vol. QE-22, no. 6, June 1986.

Optoelectronic integration on a GaAs substrate can be subdivided according to the electrical property of the substrate into devices integrated on a semi-insulating substrate (horizontal integration) and devices integrated on a conductive substrate (vertical integration).

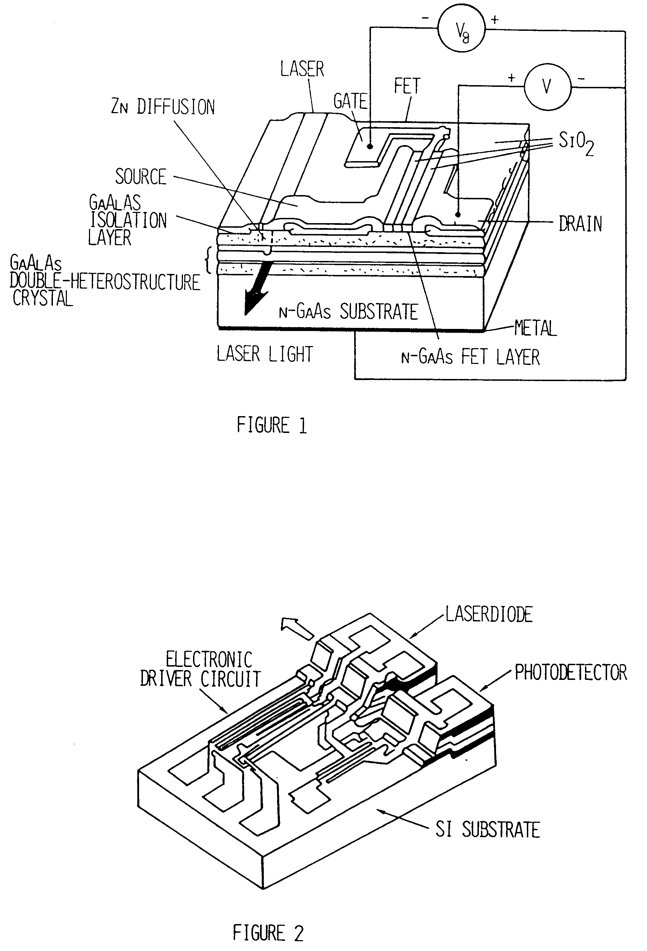

From a historical point of view most attention in the beginning was focussed on integration circuits based on a conductive substrate. As an example thereof we mention the monolithic integration of a GaA1As injection laser with a Schottky gate field effect transistor (FET) (T.Fukuzawa et al., Appl.Phys.Lett. 36 (3), 1 Feb. 1980), represented in fig.1.

European patent application 199 852 relates to the monolithic integration of an array of light emitting diodes and driver electronics on a common conductive p-type Gallium arsenide substrate.

The main reason for use of a conductive substrate is the permanent planar character of the substrate surface, which facilitates a number of technological aspects such as high-resolution photolithography. In such an integration strategy, however, an undoped insulating buffer layer, which is necessary for the electric separation of the various components, has to be applied. The difficulty thereof combined with leakage currents through the buffer layer as well as capacitive connections because of the presence of the conductive substrate result in parasitic interactions between the various components. Therefore, the integration research is nowadays strongly focussed on horizontal circuits. Herein a lot of attention is given to the planarisation of the substrate surface. The non-planar character has its origin in the contacting of the optoelectronic components. As an example of horizontal integration the classical integration of a laser-monitor-driver circuit (H.Matsueda et al., IEE Proceedings, Vol. 131, Pt.H, no. 5, 5 Oct. 1984) is represented in fig. 2. By the use of characteristic non-planar LPE growth over the channels etched in the substrate a quasi-planar structure is obtained.

Integration of a single laser diode or photodiode with an electronic semi-conductor element (FET) on a semi-insulating subtrate has been described in European patent application EP 0 162 677. This document does not deal with the integration and mutual insulation of arrays of elements.

### Objects of the invention

It is a first object of the present invention to provide a complex optoelectronic monolithic circuit comprising an array of light sources and the associated driver electronics. The present state of the art of the optoelectronically integrated circuits limits itself mainly to the integration of individual light sources with driver electronics for telecommunication applications. The integration of an array of light sources with typical integration densities of 16 and 32 sources per mm, which are of essential importance for the electronic image systems, is an important further step in the present research of integration.

Another object is the integration of the light sources with the associated driver electronics on a semi-insulating GaAs substrate.

Another object is to provide a suitable planarisation scheme in order to make high integration densities possible.

Other objects of the present invention will become apparent from the description hereinafter.

### Statement of the invention

These and other objects of the present invention are achieved by forming an integrated device, comprising an array of mutually insulated double heterostructure light emitting diodes (LED) and associated driver field effect transistors (FET) on a common semi-insulating GaAs substrate, said method comprising the following sequence of steps :
- etching at least one channel in a surface of said semi-insulating GaAs substrate,
- growing a doped GaAs contact layer of a first conductivity type in said channel(s), said contact layer being restricted to said channel (s),
- growing on the entire device surface a multilayer structure comprising, a first cladding layer of a ternary compound AlₓGa₁₋ₓAs of a first conductivity type, a second light emitting GaAs layer or a doped Al_{y}Ga_{1-y}As layer of said first conductivity type on top of said first layer, a third cladding layer of ternary compound AlₓGa₁₋ₓAs of a second conductivity type on top of said second layer and a fourth doped GaAs contact layer of said second conductivity type on said third LED layer,
- removing in substance said multilayer structure from the substrate surface outside said channel(s) by subsequent selective etching steps, thereby forming a graded step profile of the remaining portions of the multilayer structure at the channel edge(s) adjacent to the surface area of the substrate intended for FET formation,
- depositing a SiO₂ layer on the entire device surface, and etching the SiO₂ layer on locations intended for FET formation by the side of said graded step profile(s),
- forming on said locations a multiplicity of FET structures by selectively growing for each FET to be formed on top of each other an undoped GaAs buffer layer, a GaAs active FET layer, a protective AlGaAs caplayer,
- removing said SiO₂ layer by etching,
- selectively etching said AlGaAs caplayer to make mutual FET insulation possible, the intended individual active FET areas remaining still protected by caplayer portions,
- etching the remaining portions of the multilayer structure so as to remove selectively said fourth GaAs contact layer from the upper cladding layer to reduce current crowding and to obtain good optical confinement for the LEDs,
- mutually insulating said individual LEDs and FETs by boron implantation into said exposed active FET and third cladding layers or by wet mesa etching,
- depositing a SiNₓ layer or a SiO₂ layer on the entire device surface,
- etching said SiNₓ or SiO₂ layer to permit formation of contacts and removal of the remaining caplayer portions in the FET area,
- removing the remainder of said caplayer,
- forming ohmic n-type and ohmic p-type contacts on the LEDs and on sources and drains of the FETs, and forming LED-FET interconnections,
- forming FET schottky gate contacts,
- forming an additional metal layer on said LED-FET interconnections,
- selectively removing portions of the remaining fourth GaAs contact layer from the LEDs to form a LED window.

Preferred embodiments of the invention are set out in the dependent claims.

The invention can be applied for the production of recording modules to be assembled in a recording head for linewise recording information upon a photoreceptor, said recording head being built up by a plurality of recording modules arranged so that an uninterrupted row of light-emitting elements is formed along the length of said recording head.

### Brief description of the drawings:

The invention will be described hereinafter with reference to the accompanying drawings, wherein :
- Fig. 1 shows a prior art optoelectronic device integrated on a conductive GaAs substrate (T.Fukujawa et al. in Appl.Phys.Lett., 36 (3), 1 feb. 1980);
- Fig. 2 shows a prior art optoelectronic device integrated on a semi-insulating GaAs substrate (H.Matsueda et al., IEE Proceedings, Vol. 131, Pt.H., no. 5, 5 Oct. 1984);
- Fig. 3 is a diagrammatic view of an embodiment of a recording apparatus wherein a recording head comprising an integrated circuit according to the present invention could be used;
- Fig. 4 is a diagrammatic view of the electronic configuration of one LED and one field-effect transistor (FET);
- Fig. 5 is a view of the configuration of an integrated circuit comprising a LED and two FETs;
- Fig. 6a to q are diagrams of the subsequent integrations steps;
- Fig. 7a to e show the specific etch strategy to obtain a graded step profile;
- Fig. 8a shows the selectivity curve of the KI:I₂ etching system;
- Fig. 8b shows the selectivity curve of the NH₄OH:H₂O₂ etching system;
- Fig. 9 show the transfer characteristic of a driver FET;
- Fig. 10 shows the output characteristic of the same driver FET;
- Fig. 11 shows the I-V characteristic of a LED;
- Fig. 12 shows the light-output characteristic of the same LED;
- Fig. 13 shows the output characteristic when LED and FET are connected in series;
- Fig. 14 shows the radiated-light intensity of a LED as a function of the gate potential of a driving FET;
- Fig. 15 shows a LED-multiplexing system enabling reduction of the number of driver transistors.

Figure 1 and 2 show an example of the two kinds of optoelectronic monolithic integrations, the first one (fig. 1) having been integrated on a conductive substrate and the second one (fig. 2) having been integrated on a semi-insulating substrate.

Figure 1 shows a double heterostructure LASER (DH LASER) and a MESFET integrated on a n-type doped GaAs substrate. The electric insulation between the DH LASER and the MESFET is achieved by an AlGaAs insulating layer.

Since electrical contacts of the optical devices can be provided on the backside of the device, optical and electronic components can be grown near to each other, allowing a reduction of surface steps on the wafer. This kind of integration on a conductive substrate suffers from the necessary fabrication of an insulating layer (characterised by its high resistivity), from parasitic interaction between components on the wafer and from parasitic effects caused by leakage currents through the insulating layer.

Figure 2 shows the integration of a laser diode, a photodetector and 6 transistors on a semi-insulating substrate. By the use of non-planar liquid-phase epithaxy (further on referred to as LPE) on a channeled substrate a quasi-planar surface is obtained. In every integration scheme that is based on the use of a semi-insulating substrate, much attention is to be paid to the planarisation of the surface in order to enable realization of complex, high-density circuits.

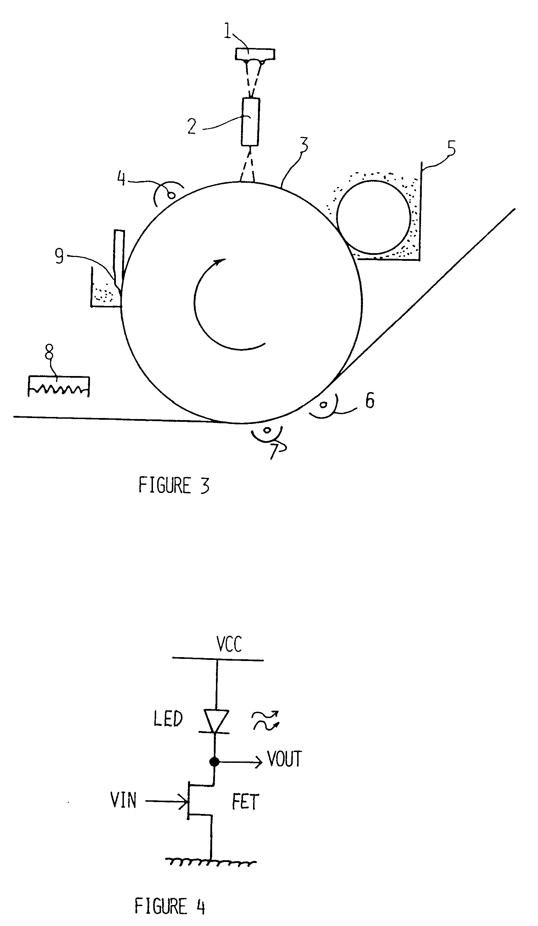

Referring to figure 3, a recording apparatus is shown for linewise recording information upon a moving photoreceptor. The apparatus comprises basic elements known in the art, namely a recording head (1) that is provided with a plurality of light-emitting elements and electronic driver circuits for these light-emitting elements, optical transfer means (2) for transferring and focusing the emitted light, and a photoreceptor (3) in the form of a cylindrical surface of a drum. The presentation of the photoelectric surface in the form of a drum is merely for illustrative purposes and may take another form, e.g. the form of a belt.

The apparatus comprises a corona-discharge station (4) that electrically charges the surface of the rotating drum. The areas of the drum surface that are exposed by the emitters become discharged, whereas the others maintain their charge. The electrostatic charge pattern thus produced is developed by a developing station (5) wherein a developer composition is brought into contact with the charge pattern on the drum. A corona-transfer station (6) transfers the toner pattern from the drum surface onto a paper sheet so that a permanent copy is obtained. A corona-separator station (7) is effective to separate the paper sheet from the drum. A fuser station (8) is applied for fusing the toner pattern on the sheet so that a permanent copy is obtained. A cleaner station (9) may be operative to remove the excess of toner from the drum surface before a next exposure is made.

The above-mentioned recording head can consist e.g. of an integrated LED-array together with the associated driving circuits that are connected to the light-emitting elements by wire-bonding. It could also be replaced by a recording head comprising a number of aligned modules, each of said modules consisting of a number of LEDs and associated driver circuitry on one single substrate.

An integrated embodiment is much more reliable than the wire-bonded embodiment.

Such an embodiment has a further advantage that each of the modules can be tested before it is incorporated in the recording head or it can be replaced when some defects would occur.

Figure 4 shows the basic configuration of a LED and a FET structure that are connected in series so that the transistor determines the current through the diode. In one module several diodes have a common anode configuration and are each connected to a driver by their cathode terminal. In further applications, a logic circuit based on MESFET can be connected to the basic LED-driver circuit by the gate electrode of the MESFET.

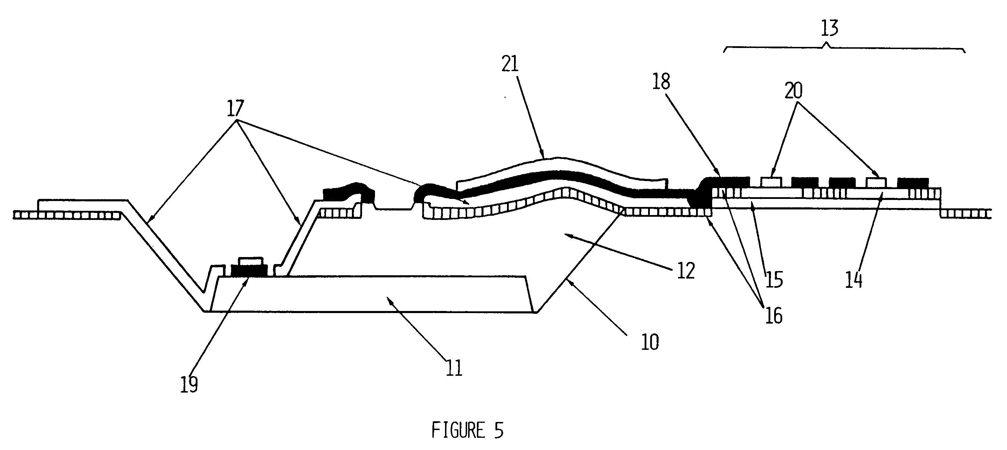

Figure 5 shows the configuration of one LED and two MESFETS. These devices are integrated on a common semi-insulating GaAs substrate in accordance with the present invention. In a semi-insulating GaAs substrate channels (10) are wet chemically etched. A p⁺ LED-anode contact layer (11) grown by MOCVD (metal organic chemical vapour deposition) is formed, either by wet chemical etching or selective MOCVD growth. Over this structure, non-planar LPE or MOCVD is applied to form the LED structure. The LED structure (12) is restricted to the channel by a multiple photolithographic process combined with the use of selective etchants. At the right side of the channel a graded step profile with a quasi-planar surface is in this way obtained in the vicinity of the electronic circuit (13). At the left side there is no need for fine line patterning since only p-type bonding pads (100 µm side) are to be formed. With this configuration a reduced LED series resistance, due to a thick p⁺-layer and a short distance between LED-anode and LED-cathode contacts, is obtained

After LED formation an undoped buffer layer (15) and the active FET layer (14) on top of said undoped buffer layer (15) (and a protective Al₇₀Ga₃₀As caplayer (see later)) are selectively grown by MOCVD. FETs are insulated by boron implantation (16) or by wet chemical mesa-etching. At the same time a supplementary LED insulation (optical confinement) is carried out. A SiNₓ or SiO₂ layer (17) is deposited to obtain a good step coverage and to reduce parasitic effects and short circuit of the LED at the edge of the channel. This layer is also used to obtain a good LED optical confinement when FET mesa-etching is used. Ohmic n-type contacts (18) for FET formation and to interconnect LEDs and FETs and ohmic p-type LED anode contacts (19) are formed. FET-Schottky contacts and an additional metallisation to reduce LED and FET series resistance are denoted with reference numbers 20 and 21.

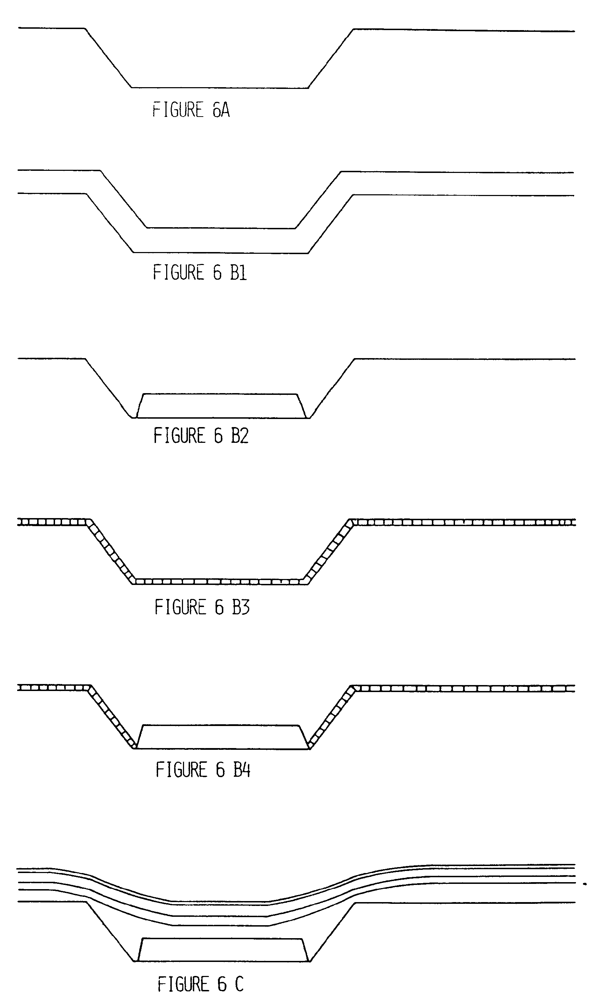

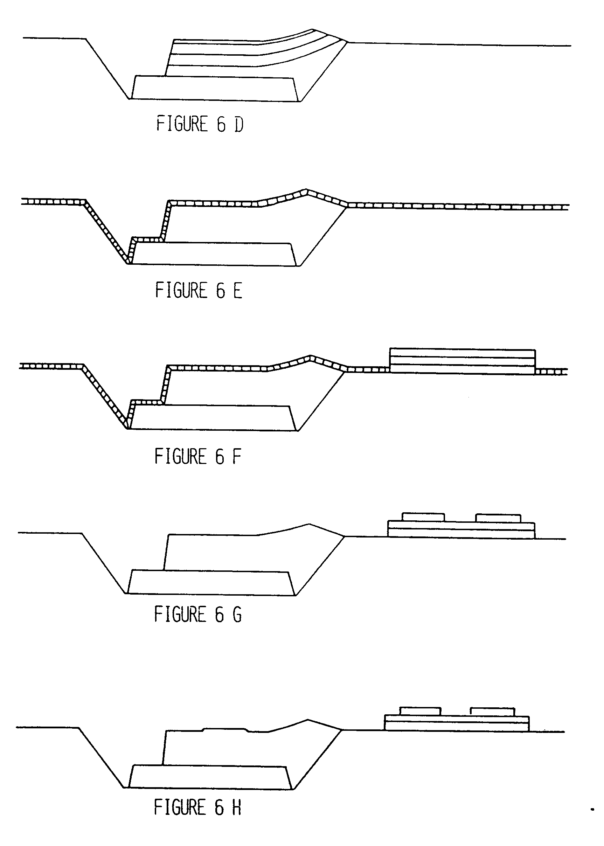

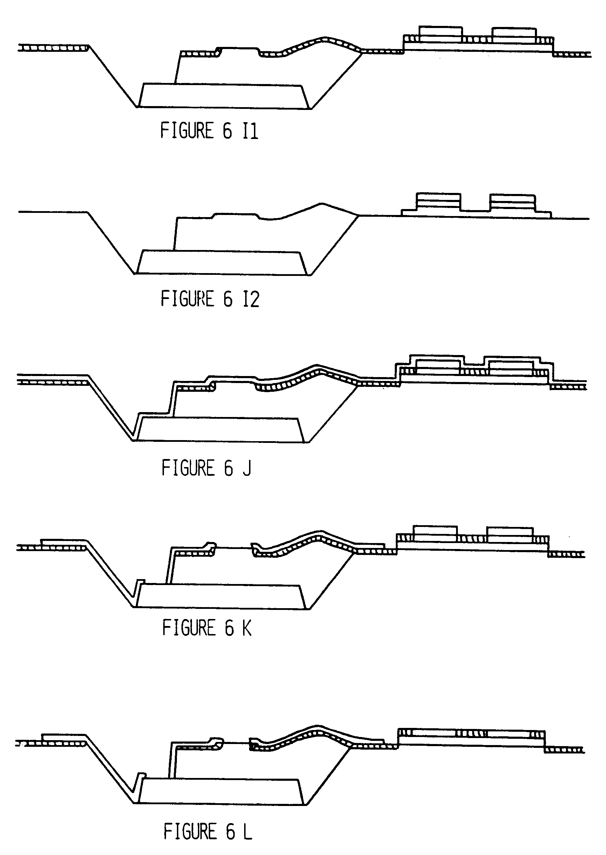

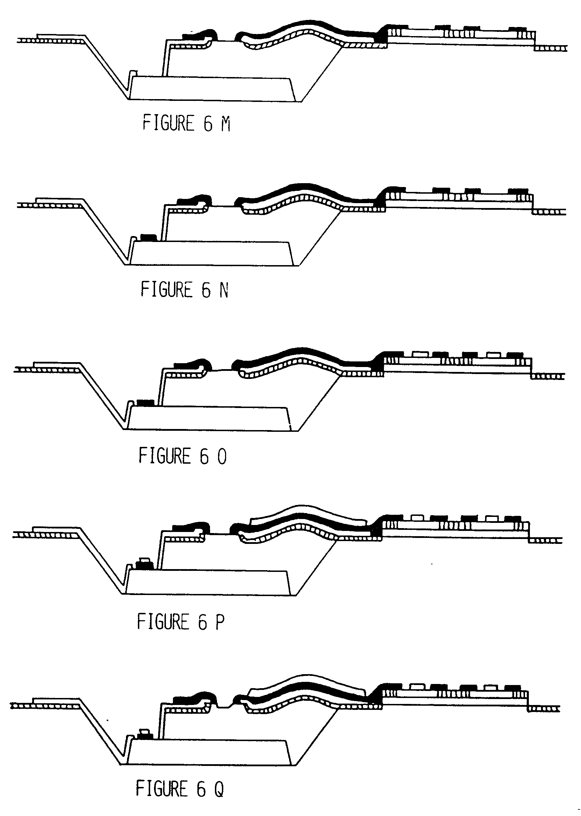

Figure 6 describes the subsequent processing steps for the integration of the LED array with driver MESFETs on a common semi-insulating GaAs substrate.
- Fig. 6a : the first processing step consists of etching optochannels in the semi-insulating substrate. The depth of the channels is equal to the total LED-structure thickness plus the thickness of a p⁺-contact layer. The channels are first etched with a H₂SO₄ solution (composition 1 H₂SO₄ : 8 H₂O₂ : 11 H₂O abbreviated as 1:8:11 parts by volume) followed by a polishing etching of the entire surface with a 5:1:1 solution. As a result of the last etching the surface is cleaned from contamination and work damage and the channel corners are rounded. The depth of the channels remains unaltered.
- Fig. 6b : next the anode contact layer is formed. Two possible ways of forming the anode-contact layer can be envisioned. In fig. 6b1 a p⁺-layer is grown by MOCVD over the entire surface. This layer is wet chemically etched in a H₂SO₄ solution (1:8:11). (cfr. figure 6b2) In the alternative way first a 100 nm SiO₂ oxide layer is plasma-deposited (fig. 6b3) and dry plasma-etched according to fig. 6b4. Next the p⁺ layer is selectively grown by MOCVD. On the oxide surface only polycrystalline GaAs is deposited. With the use of a photoresist mask this polycrystalline GaAs is removed with a H₂SO₄ solution, followed by plasma-etching of the oxide layer. The result is the same as depicted in fig. 6b2. The p⁺-layer itself is to be doped as highly as possible (exceeding 10¹⁹ cm⁻³) while its thickness is chosen to be 2 micrometer as a result of a compromise between LED-series resistance (low if p⁺-layer is thick) and depth of the optochannel.
- Fig. 6c shows the growth of a four-layer double heterostructure LED by means of LPE (in case of the figure) or MOCVD. In case of a visible-light-emitting LED a light-emitting p-type Al₃₀Ga₇₀As layer is sandwiched between two Al₇₀Ga₃₀As cladding layers, the lower of type p and the upper of type n. In case of an infrared-emitting LED one has a GaAs active layer and Al₃₀Ga₇₀As cladding layers. All layers so far mentioned are 1 micrometer thick. To obtain a good ohmic n-type contact, a n⁺-GaAs contact layer of 300 nm thickness is grown on top of this structure. The whole structure is deposited over the entire surface in one growth run.

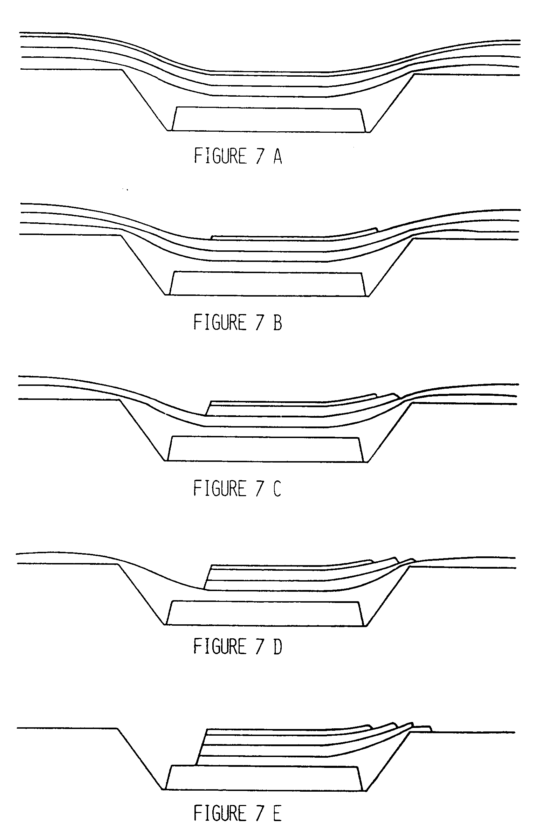

- Fig. 6d : the LED structure is wet chemically etched according to a specific etching strategy based on multiple photolithographic steps combined with the use of selective etchants. This strategy is further explained in fig. 7. At the right side of the optochannel, in the near vicinity of the electronic circuit, a graded-step profile is obtained, which makes fine-line patterning necessary for the electronic circuit and high-yield LED-FET interconnection possible. At the left side important surface steps are induced but locally there is no need for high-resolution photolithographics while the LED-series resistance is reduced due to the short distance between LED-anode and LED-cathode contacts. Another advantage of this structure is a strictly vertical current flow through the LED structure. This is often not the case when the p⁺-layer extends out of the channel.
- Fig. 6e : a SiO₂ layer, 100 nm in thickness, is plasma-deposited over the entire surface.
- Fig. 6f : the SiO₂ layer is plasma-etched and a sandwich structure consisting of an undoped GaAs buffer layer (300 nm), a GaAs active FET layer (150 nm, n=10¹⁷ cm⁻³), and a protective Al₇₀Ga₃₀As caplayer, is selectively grown by MOCVD. After wet-etching of the polycrystalline material on top of the SiO₂ layer, the SiO₂ layer is plasma-etched. The use of the buffer layer makes that the active FET layer is grown on a clean surface free from any contamination and that the growth morphology is very good. The Al₇₀Ga₃₀As caplayer protects the active layer during subsequent processing steps. Special deposition and dry etching of the SiNₓ insulating layer (fig. 6j and 6k) damage the active layer and make FET action impossible. The whole structure is grown in a one MOCVD run.
- Fig. 6g : the Al₇₀Ga₃₀As layer is selectively etched by using a KI:I₂ solution. This is necessary to make FET insulation (fig.6i) possible. The individual active FET areas are still protected by the caplayer.

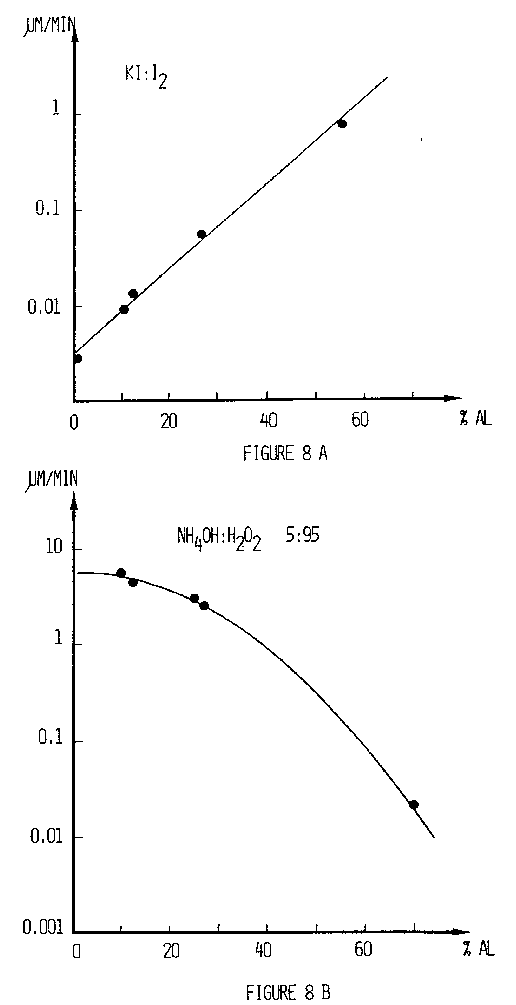

- Fig. 6h : LED mesas are selectively wet-etched by means of a NH₄OH:H₂O₂ solution. The n⁺-GaAs top layer is selectively removed from the upper AlGaAs-cladding layer so as to reduce current crowding and to obtain good optical confinement. Details concerning selective etchants are given with reference to figures 8a en 8b.
- Fig. 6i) : insulation between FETs is obtained by a boron implantation with energy 40 keV, dose 10¹³ cm⁻² (isotope B¹¹) (fig. 6i1). At the same time the LEDs are supplementarily insulated (optically) by means of implantation into the upper AlGaAs cladding layer. As an alternative (fig. 6i2) wet mesa-etching with a H₂SO₄ solution or a selective etchant can be applied. At the same time supplementary LED insulation can be obtained by etching the upper AlGaAs cladding layer.
- Fig. 6j : a 500 nm SiNₓ or SiO₂ layer is plasma-deposited. This layer provides good step coverage, reduction of parasitic effects and prevents LED short circuit at the edge of the optochannel.
- Fig. 6k : plasma etching of the previously mentioned SiNₓ or SiO₂ layer.
- Fig. 6l : prior to ohmic-contact definition the remaining Al₇₀Ga₃₀As protective caplayer is removed. A selective etchant (KI:I₂) is used.
- Fig. 6m : the ohmic n-type contact (FET source and drain and interconnection metal LED-FET) is formed. It consists of 150 nm evaporated AuGe and 60 nm sputtered Ni. This metal is fast alloyed at 450 C for a few seconds.
- Fig. 6n : formation of the ohmic p-type contact. A 30 nm thick sputtered Zn layer and a 200 nm thick evaporated Au layer are fast alloyed at 420°C for a few seconds. As an alternative the AuGe/Ni system described in fig. 6m can be used since the doping of the p⁺-layer is very high (10¹⁹ cm⁻³).
- Fig. 6o : formation of FET Schottky contacts. The metal consists of 60 nm sputtered TiW and 150 nm evaporated Au.
- Fig. 6p : an additional metal layer is formed, which results in a reduction of LED-FET series resistance and which eliminates occasional cracks in the interconnecting metal. A combination of 60 nm evaporated AuGe (adhesive layer) and 150 nm evaporated Au is used.
- Fig. 6q : to avoid reabsorption of the emitted light of the LEDs the GaAs top layer of the LED multistructure is removed selectively with a NH₄OH:H₂O₂ solution.

Fig. 7 illustrates the specific etch strategy used to obtain a graded step profile at the edge of the channel. Fig. 7a shows the situation after epitaxial growth of the LED structure. In fig. 7b the first GaAs top layer is selectively etched with a NH₄OH:H₂O₂ solution. Alignment is approximative 40 µm away from the upper channel edge. In a second step (fig. 7c) the AlGaAs cladding layer is selectively etched away from the active layer. A KI:I₂ mixture is used and alignment is 10-15 microns away from the GaAs top-layer edge. In fig. 7d the active layer is selectively etched from the lower AlGaAs cladding layer. The NH₄OH:H₂O₂ solution is used and alignment is 10-15 microns away from the previous edge. In the last step (fig. 7e) the lower AlGaAs cladding layer is selectively etched from the substrate and the p⁺-layer. Here the KI:I₂ system is used with a same alignment strategy.

Fig. 8 : upon making the LED-FET combination an AlₓGa₁₋ₓAs layer has to be etched away at regular times without any underlying GaAs or Al_{y}Ga_{1-y}As layer (x greater than y) being affected. For that purpose an etchant on the basis of KI and I₂ is used. This combination as such is known in literature for its selective properties, but the system we developed is clearly superior with respect to the results.

In order to achieve this proper selectivity it is necessary to pay some attention to the pH of the solution. A solution of 25.8 g of KI in 25 ml of H₂O is adapted to have a pH between 1 and 2 by the addition of dilute H₃PO₄ (1:8 diluted in H₂O). After the addition of 16.25 g of I₂ the etchant can be used immediately. In fig. 8a the rate of etching is represented as a function of the percentage of Al in the layer to be etched. Between Al₇₀Ga₃₀As and GaAs a selectivity better than 1/1000 is reached. Upon etching Al₇₀Ga₃₀As with respect to Al₃₀Ga₇₀As and of Al₃₀Ga₇₀As with respect to GaAs selectivities have been noted of 1/60 and 1/25 respectively.

Increasing the pH modifies the selectivity obtained. A pH between 5 and 7 does not make the mixture selective, whereas still higher values (pH greater than 8) preferentially etch GaAs with respect to AlGaAs. As such the etchant is not used because for this application the NH₄OH:H₂O₂ system yields better results.

Upon using an NH₄OH:H₂O₂ etching system the traditional and frequently used mixture with controlled pH was abandoned. Herein H₂O₂ is diluted with NH₄OH to obtain a pH between 7.02 and 7.05. This etchant shows a good selectivity but has very low etching speeds.

In trying to realize the present invention the etching times are inadmissibly long. Therefore, one has passed to a less known etchant, whereby a solid composition is used. For that purpose H₂O₂ (95 parts) are mixed with NH₄OH (5 parts). The speed of etching as a function of the percentage of Al in the layer is represented in fig. 8b. As appears from the graph the selectivity of GaAs with respect to Al₇₀Ga₃₀As is perfect (better than 1000/1).

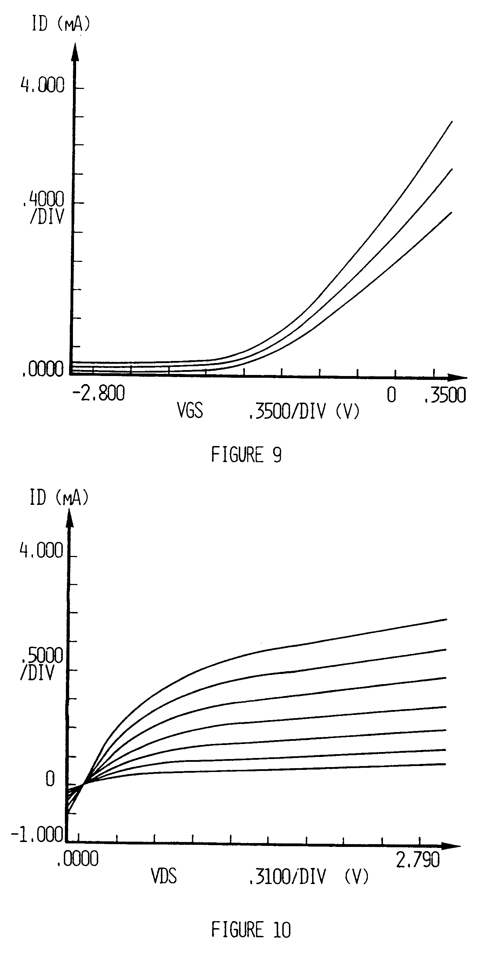

Fig. 9 shows the transfer characteristic of a driver FET with channel length L = 10 microns and channel width W = 400 microns. This figure is a plot of the drain current of the FET versus the gate-source potential with the drain-source potential as a parameter. Transistor threshold voltage is measured to be 1.75 V.

Fig. 10 shows a direct plot of the output characteristic of the same driver FET. Here the drain current is measured versus drain-source potential and the gate-source potential is a parameter.

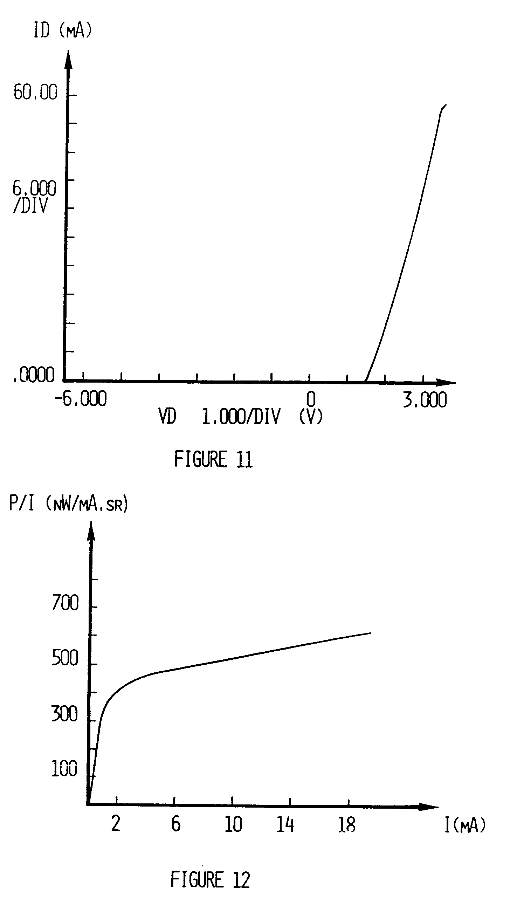

Fig. 11 shows the I versus V characteristic of a LED. Threshold voltage Vₛ is approximately 1.4 V.

Fig. 12 shows the light-output characteristic of the same LED. Emitted power P per steradian and per mA is measured versus LED current.

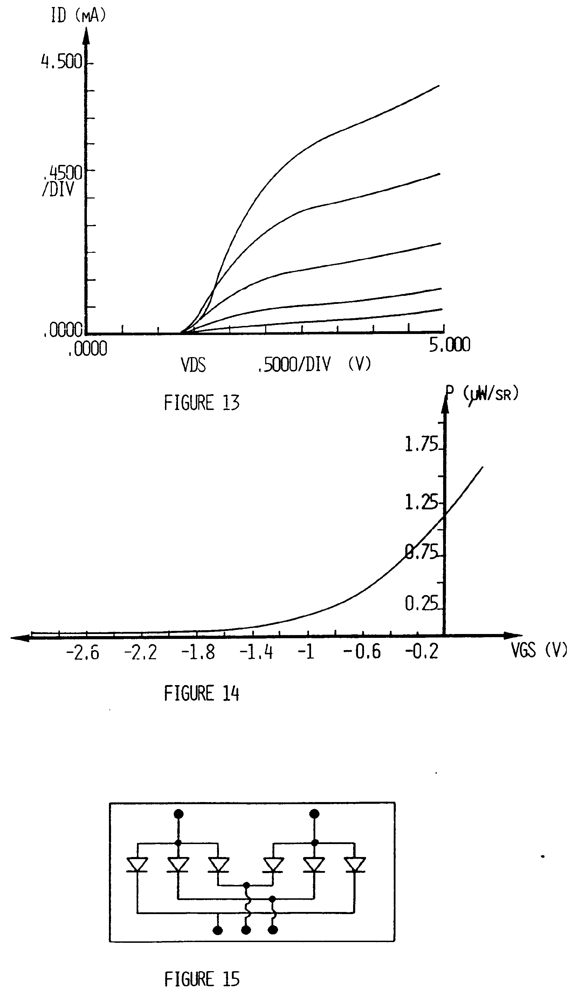

Fig. 13 represents the static characteristic of the complete optoelectronic device. The figure shows a direct plot of the measured combination of the FET and LED characteristic. LED and FET were connected in series. For power supplies lower than the LED-threshold voltage a cutoff behaviour is observed. For power supplies exceeding Vₛ the serial current between LED and FET can be varied between the FET current for a gate potential of 0 Volt, and cut off when the FET threshold voltage is applied to the gate electrode.

Fig. 14 represents the optical transfer characteristic for V_{CC} exceeding Vₛ. The transistor is used as a current source so that the optical output intensity can be modulated between 0 and the value corresponding with a FET-gate potential of 0 Volt.

Fig. 15 shows the principle of multiplexed LED-driving. By taking the anode not in common over the entire LED array but only over subblocks of the array, one can drive the cathode of different LEDs by means of the same driver. Such an approach is only possible when using an insulating substrate wherein such subblocks are physically realized by applying grooves in the p⁺-contact layer.

## Claims

1. Method of forming an integrated device comprising an array of mutually insulated double heterostructure light emitting diodes (LED) and associated driver field effect transistors (FET) on a common semi-insulating GaAs substrate, said method comprising the following sequence of steps :
- etching at least one channel in a surface of said semi-insulating GaAs substrate,
- growing a doped GaAs contact layer of a first conductivity type in said channel(s), said contact layer being restricted to said channel(s),
- growing on the entire device surface a multilayer structure comprising, a first cladding layer of a ternary compound AlₓGa₁₋ₓAs of a first conductivity type, a second light emitting GaAs layer or a doped Al_{y}Ga_{1-y}As layer of said first conductivity type on top of said first layer, a third cladding layer of ternary compound AlₓGa₁₋ₓAs of a second conductivity type on top of said second layer and a fourth doped GaAs contact layer of said second conductivity type on said third LED layer,
- removing in substance said multilayer structure from the substrate surface outside said channel(s) by subsequent selective etching steps, thereby forming a graded step profile of the remaining portions of the multilayer structure at the channel edge(s) adjacent to the surface area of the substrate intended for FET formation,
- depositing a SiO₂ layer on the entire device surface, and etching the SiO₂ layer on locations intended for FET formation by the side of said graded step profile(s),
- forming on said locations a multiplicity of FET structures by selectively growing for each FET to be formed on top of each other an undoped GaAs buffer layer, a GaAs active FET layer, a protective AlGaAs caplayer,
- removing said SiO₂ layer by etching,
- selectively etching said AlGaAs caplayer to make mutual FET insulation possible, the intended individual active FET areas remaining still protected by caplayer portions,
- etching the remaining portions of the multilayer structure so as to remove selectively said fourth GaAs contact layer from the upper cladding layer to reduce current crowding and to obtain good optical confinement for the LEDs,
- mutually insulating said individual LEDs and FETs by boron implantation into said exposed active FET and third cladding layers or by wet mesa etching,
- depositing a SiNₓ layer or a SiO₂ layer on the entire device surface,
- etching said SiNₓ or SiO₂ layer to permit formation of contacts and removal of the remaining caplayer portions in the FET area,
- removing the remainder of said caplayer,
- forming ohmic n-type and ohmic p-type contacts on the LEDs and on sources and drains of the FETs, and forming LED-FET interconnections,
- forming FET schottky gate contacts,
- forming an additional metal layer on said LED-FET interconnections,
- selectively removing portions of the remaining fourth GaAs contact layer from the LEDs to form a LED window.

2. A method according to claim 1 wherein said channel(s) is (are) obtained by wet chemical etching.

3. A method according to claim 1 wherein said contact layer is grown in and is restricted to said channel(s) by selective MOCVD-growth or by MOCVD-growth combined with wet etching.

4. A method according to claim 1 wherein said LEDs are formed by non-planar epitaxial growth by means of MOCVD or LPE technique.

5. A method according to claim 1 wherein said LEDs are planarized at the edge(s) of said channel(s) by means of a multiple photolithographic process and selective wet etching.

6. A method according to claim 1 wherein said undoped GaAs buffer layer, said GaAs active FET layer and said AlGaAs caplayer are formed by means of a one run selective MOCVD growth process.

7. A method according to claim 1 wherein the edge(s) of the channel(s) are protected by portions of said SiNₓ or SiO₂ layers to prevent LED short circuit.

## Patentansprüche

1. Verfahren zum Bilden einer integrierten Vorrichtung mit einem Feld gegenseitig isolierter Leuchtdioden (LED) mit Doppelheterostruktur und zugehörigen Treiber-Feldeffekttransistoren (FET) auf einem gemeinsamen halbisolierenden GaAs-Substrat mit folgender Schrittfolge:
- Einätzen mindestens eines Kanals in eine Oberfläche des besagten halbisolierenden GaAs-Substrats,
- Züchten einer dotierten GaAs-Kontaktschicht eines ersten Leitfähigkeitstyps in besagtem Kanal (besagten Kanälen), wobei die besagte Kontaktschicht auf besagten Kanal (besagte Kanäle) beschränkt ist,
- Züchten auf der gesamten Vorrichtungsoberfläche einer Mehrschichtstruktur mit einer ersten Mantelschicht einer Dreifachverbindung AlₓGa₁₋ₓAs eines ersten Leitfähigkeitstyps, einer zweiten lichtemittierenden GaAsSchicht oder einer dotierten Al_{y}Ga_{1-y}As-Schicht des besagten ersten Leitfähigkeittyps auf der besagten ersten Schicht, einer dritten Mantelschicht der Dreifachverbindung AlₓGa₁₋ₓAs eines zweiten Leitfähigkeitstyps auf der besagten zweiten Schicht und einer vierten dotierten GaAs-Kontaktschicht des besagten zweiten Leitfähigkeitstyps auf der besagten dritten LED-Schicht,
- Entfernen im wesentlichen der besagten Mehrschichtstruktur von der Substratoberfläche außerhalb des besagten Kanals (der besagten Kanäle) durch nachfolgende gezielte Ätzschritte, wodurch ein gradiertes Stufenprofil der übrigen Teile der Mehrschichtstruktur an dem Kanalrand (den Kanalrändern) neben dem für die FET-Bildung bestimmten Oberflächenbereich des Substrats gebildet wird,
- Ablagern einer SiO₂-Schicht auf der gesamten Vorrichtungsfläche und Ätzen der SiO₂-Schicht an für die FET-Bildung bestimmten Stellen an der Seite des besagten gradiertes Stufenprofils (der besagten gradiertes Stufenprofile),
- Bilden einer Mehrzahl von FET-Strukturen an besagten Stellen durch gezieltes Züchten einer undotierten GaAs-Pufferschicht, einer GaAs-aktiven FET-Schicht, einer AlGaAs-Schutzschicht übereinander für jeden FET,
- Entfernen der besagten SiO₂-Schicht durch Abätzen,
- gezieltes Ätzen der besagten AlGaAs-Schutzschicht zum Ermöglichen einer gegenseitigen FET-Isolierung, wobei die beabsichtigten einzelnen aktiven FET-Bereiche immer noch durch Schutzschichtteile geschützt bleiben,
- Ätzen der übrigen Teile der Mehrschichtstruktur zur selektiven Beseitigung der besagten vierten GaAs-Kontaktschicht von der oberen Mantelschicht zur Reduzierung von Stromverdichtung und um gute optische Begrenzung für die LED zu erhalten,
- gegenseitige Isolierung der besagten einzelnen LED und FET durch Borimplantation in besagte freigelegte aktive FET- und dritte Mantelschichten oder durch naßchemisches Mesaätzen,
- Ablagern einer SiNₓ-Schicht oder einer SiO₂-Schicht auf der gesamten Vorrichtungsfläche,
- Ätzen der besagten SINₓ- oder SiO₂-Schicht zum Ermöglichen der Bildung von Kontakten und Entfernung der übrigen Schutzschichtteile im FET-Bereich,
- Entfernen der übrigen besagten Schutzschicht,
- Bilden von ohmschen n- und ohmschen p-Kontakten auf den LED und auf Source- und Drain-Elektroden der FET und Bilden von LED-FET-Verbindungen,
- Bilden von FET-Schottky-Gatekontakten,
- Bilden einer zusätzlichen Metallschicht auf den besagten LED-FET-Verbindungen,
- gezieltes Entfernen von Teilen der übrigen vierten GaAs-Kontaktschicht von den LED zum Bilden eines LED-Fensters.

2. Verfahren nach Anspruch 1, wobei besagter Kanal (besagte Kanäle) durch naßchemisches Ätzen erhalten wird (werden).

3. Verfahren nach Anspruch 1, wobei die besagte Kontaktschicht durch selektives MOCVD-Wachstum oder MOCVD-Wachstum in. Verbindung mit Naßätzen in dem besagten Kanal (den besagten Kanälen) gezüchtet wird und auf diesen (diese) beschränkt ist.

4. Verfahren nach Anspruch 1, wobei besagte LED durch nichtplanares epitaxiales Wachstum mittels eines MOCVD- oder LPE-Verfahrens gebildet werden.

5. Verfahren nach Anspruch 1, wobei die besagten LED an dem Rand (den Rändern) des (der) besagten Kanals (Kanäle) mittels eines mehrfachen fotolithografischen Prozesses und selektiver Naßätzung planarisiert werden.

6. Verfahren nach Anspruch 1, wobei besagte undotierte GaAs-Pufferschicht, besagte aktive GaAs-FET-Schicht und besagte AlGaAs-Schutzschicht mittels eines selektiven MOCVD-Wachstumsprozesses in einem Lauf gebildet werden.

7. Verfahren nach Anspruch 1, wobei der Rand (die Ränder) des (der) Kanals (Kanäle) durch Teile der besagten SINₓ- oder SiO₂-Schichten geschützt werden, um einen LED-Kurzschluß zu verhindern.

## Revendications

1. Méthode de formation d'un dispositif intégré comprenant une matrice de diodes électroluminescentes (DEL) à double hétérostructure mutuellement isolées et de transistors à effet de champ (TEC) pilotes associés sur un substrat semi-isolant commun en GaAs, ladite méthode comprenant la séquence suivante d'étapes consistant à:
- graver au moins un canal dans une surface dudit substrat semi-isolant en GaAs,
- faire croître une couche de contact en GaAs dopé d'un premier type de conductivité dans ledit(lesdits) canal(canaux), ladite couche de contact étant restreinte audit(auxdits) canal(canaux),
- faire croître sur la surface entière du dispositif une structure multicouche comprenant une première couche de revêtement d'un composé ternaire AlₓGa₁₋ₓAs d'un premier type de conductivité, une deuxième couche de GaAs électroluminescente ou une couche de Al_{y}Ga_{1-y}As dopé dudit premier type de conductivité par-dessus ladite première couche, une troisième couche de revêtement de composé ternaire AlₓGa₁₋ₓAs d'un deuxième type de conductivité par-dessus ladite deuxième couche et une quatrième couche de contact en GaAs dopé dudit deuxième type de conductivité sur ladite troisième couche de DEL,
- enlever substantiellement ladite structure multicouche depuis la surface du substrat en dehors dudit(desdits) canal (canaux) par des étapes ultérieures de gravure sélective, formant ainsi un profil en échelons progressifs des parties restantes de la structure multicouche sur le(s) bord(s) du(des) canal(canaux) adjacent(s) à la zone de surface du substrat prévue pour la formation de TEC,
- déposer une couche de SiO₂ sur la surface entière du dispositif, et graver la couche de SiO₂ à des emplacements prévus pour la formation de TEC par le côté dudit(desdits) profil(s) en échelons progressifs,
- former auxdits emplacements une multiplicité de structures de TEC en faisant croître sélectivement pour chaque TEC à être formé l'un au-dessus de l'autre une couche tampon en GaAs non dopé, une couche active de TEC en GaAs, une couche de recouvrement protectrice en AlGaAs,
- enlever ladite couche de SiO₂ par gravure,
- graver sélectivement ladite couche de recouvrement en AlGaAs pour rendre possible l'isolation mutuelle de TEC, les zones actives de TEC individuelles prévues demeurant toujours protégées par des parties de couche de recouvrement,
- graver les parties restantes de la structure multicouche de manière à enlever sélectivement ladite quatrième couche de contact en GaAs depuis la couche de revêtement supérieure pour réduire l'encombrement de courant et pour obtenir un bon confinement optique pour les DEL,
- isoler mutuellement lesdits DEL et TEC individuels par implantation de bore dans ladite couche active exposée de TEC et dans ladite troisième couche de revêtement ou par attaque en milieu liquide de mésas,
- déposer une couche de SiNₓ ou une couche de SiO₂ sur la surface entière du dispositif,
- graver ladite couche de SiNₓ ou de SiO₂ pour permettre la formation de contacts et l'enlèvement des parties de la couche de recouvrement restantes dans la zone de TEC,
- enlever le reste de ladite couche de recouvrement,
- former des contacts ohmiques de type n et ohmiques de type p sur les DEL et sur les sources et les drains des TEC, et former des interconnexions DEL-TEC,
- former des contacts de grille Schottky de TEC,
- former une couche métallique supplémentaire sur lesdites interconnexions DEL-TEC,
- enlever sélectivement des parties de la quatrième couche de contact en GaAs restante depuis les DEL pour former une fenêtre de DEL.

2. Une méthode selon la revendication 1 dans laquelle ledit(lesdits) canal(canaux) est(sont) obtenu(s) par attaque chimique en milieu liquide.

3. Une méthode selon la revendication 1 dans laquelle ladite couche de contact est développée à l'intérieur et est restreinte audit(auxdits) canal(canaux) par croissance MOCVD sélective ou par croissance MOCVD combinée avec une attaque en milieu liquide.

4. Une méthode selon la revendication 1 dans laquelle lesdites DEL sont formées par croissance épitaxiale non-planar au moyen d'une technique MOCVD ou LPE.

5. Une méthode selon la revendication 1 dans laquelle lesdites DEL sont planarisées sur le(s) bord(s) dudit(desdits) canal(canaux) au moyen d'un processus photolithographique multiple et d'une attaque sélective milieu liquide.

6. Une méthode selon la revendication 1 dans laquelle ladite couche tampon en GaAs non dopé, ladite couche active de TEC en GaAs et ladite couche de recouvrement en AlGaAs sont formées par un processus de croissance MOCVD sélective en une seule application.

7. Une méthode selon la revendication 1 dans laquelle le(s) bord(s) du(des) canal (canaux) sont protégés par des parties desdites couches de SiNₓ ou SiO₂ pour empêcher un court-circuit de DEL.
